# DEMANDE DE BREVET EUROPEEN

(11) **EP 3 955 062 A1**
(43) Date de publication de la demande: **16.02.2022**
(21) Numéro de dépôt: 20190565.0
(22) Date de dépôt: 11.08.2020
(51) Int. Cl.: G04B 5/16, C23C 14/00, C23C 16/00, C23C 28/02, G04B 19/12, G04B 37/22, G04B 45/00, C23C 14/08, A44C 27/00, G04D 3/00

(54) **COMPOSANT NOIR ET SON PROCÉDE DE FABRICATION**

(71) Demandeur: The Swatch Group Research and Development Ltd, 2074 Marin (CH)
(72) Inventeur: MARLOT DOERR, Agnès, 2000 Neuchâtel (CH); BOURBAN, Stewes, 1589 Chabrey (CH)
(74) Mandataire: ICB SA

(57) **Abrégé**

La présente invention se rapporte à un composant d'habillage intérieur ou du mouvement pour une pièce d'horlogerie ou de bijouterie comprenant un substrat (2) revêtu au moins partiellement d'une couche noire (3) comprenant de l'oxyde d'aluminium.

Elle se rapporte également au procédé de fabrication de ce composant.

## Description

### Domaine de l'invention

L'invention se rapporte à un composant au moins partiellement revêtu de noir. Ce composant est destiné à l'habillage intérieur ou au mouvement d'une pièce d'horlogerie ou de bijouterie. Elle se rapporte également au procédé de fabrication dudit composant.

### Arrière-plan de l'invention

La « couleur » noire peut être obtenue dans la masse d'un matériau de par sa couleur intrinsèque ou via l'ajout de pigments ou colorants au sein du matériau. La «couleur» noire peut également être présente uniquement en surface. Cette coloration en surface peut être obtenue de différentes manières, généralement par oxydation/sulfuration/carburation d'un substrat métallique ou par dépôt d'un oxyde/sulfure/carbure sur un substrat. Le carbone est donc un élément bien connu pour noircir une surface. Déposé de manière longiligne sous forme de nanotubes, le matériau formé peut s'approcher d'un corps noir parfaitement absorbant allant jusqu'à donner des coefficients d'absorption de lumière de 99,96% dans le visible et proche infrarouge. Ce noir est si parfait qu'il peut cacher des formes 3D d'un objet vu de face.

L'utilisation de revêtements noirs est connue dans le domaine horloger. Du document EP 3 327 517, on connait un cadran avec un premier substrat revêtu d'une couche noire de nanotubes faisant face au verre de montre et avec un deuxième substrat fixé au premier substrat sur la surface opposée au verre. Le premier substrat est ajouré afin de réaliser des ouvertures faisant office de fenêtres destinées à former des index. Le deuxième substrat comprend un revêtement luminescent au moins dans les zones en regard des ouvertures de manière à créer un contraste au niveau du premier substrat entre la couche noire et les index illuminés.

Ainsi, le contraste est obtenu via la superposition de deux substrats présentant des revêtements distincts. Cette superposition permet d'éviter de déposer de manière sélective l'un et l'autre revêtement sur une même surface et de manipuler plus que nécessaire la couche de nanotubes qui est particulièrement fragile. Cette superposition a néanmoins pour inconvénient de requérir la fabrication de deux substrats ce qui augmente les coûts de production.

Du document CH 711 141, on connaît un procédé de fabrication d'un cadran où le décor, à savoir des index, est apposé sur le revêtement en noir de carbone. Le décor est fabriqué séparément du cadran et ensuite simplement rapporté ce qui permet de faciliter grandement la fabrication du cadran.

A l'heure actuelle, ces dépôts absorbants ultra-noirs sont formés d'une forêt de nanotubes de carbone à croissance verticale utilisant une méthode de dépôt chimique en phase vapeur. Pour maximiser l'aspect noir profond du revêtement sur un substrat, la majorité des nanotubes de carbone doit être déposée dans une orientation contrôlée et perpendiculaire au substrat. Ce procédé appliqué directement sur les pièces horlogères est complexe à mettre en œuvre. Dans un autre procédé, des peintures ou vernis à base de nanotubes de carbone peuvent être appliqués par sprayage. Ce second procédé est plus facile à mettre en œuvre mais donne des noirs moins profonds. Dans les deux cas, l'application et l'utilisation de nanotubes de carbone est complexe à mettre en œuvre et peut présenter des dangers potentiels en termes de sécurité au cours de la fabrication des revêtements, de l'assemblage des pièces horlogères et des opérations SAV. Par ailleurs, la structure en forêt du revêtement à base de nanotubes de carbone le rend très fragile et difficile à manipuler. Ces revêtements ont une très faible résistance mécanique et sont facilement écrasés même sous l'effet de légères pressions mécaniques. La couche peut être à ce point friable qu'il est quasi impossible de la toucher sans dégrader la surface, montrant des voiles brillants voire des trous contrastant avec la couleur originale des nanotubes de carbone. En outre, la structure en forêt du revêtement ne permet pas l'application en surface d'un décor sus-jacent par des techniques de printing direct usuelles.

### Buts de l'invention

La présente invention a pour but de pallier aux inconvénients des revêtements à base de nanotubes de carbone en proposant un autre type de revêtement noir ultra-absorbant, plus résistant et plus compact pour permettre les opérations usuelles de manipulation et décoration dans le domaine de l'horlogerie ou de la bijouterie.

Selon l'invention, le revêtement noir comporte un oxyde métallique et en particulier de l'oxyde d'aluminium déposé par des procédés de type PVD, CVD ou PECVD. Ce revêtement décoratif ultra-noir présente pour caractéristiques d'avoir:
- une réflectance inférieure à 1.5% et une valeur de luminance L dans le système CIELAB inférieure à 12 et de préférence à 7 permettant des contrastes de brillance et de couleurs élevés par rapport à un décor ;
- une structure compacte permettant de rapporter des décors en surface du revêtement ;
- une épaisseur micrométrique permettant la mise en valeur de pièces présentant une géométrie de surface complexe et/ou un décor horloger caractéristique ;
- une résistance mécanique permettant un assemblage des pièces revêtues dans la montre ou leur manipulation pour des opérations de décor.

La présente invention se rapporte au composant au moins partiellement revêtu avec ce revêtement noir ainsi qu'au procédé de fabrication dudit composant.

D'autres caractéristiques et avantages de la présente invention apparaîtront dans la description présentée en référence aux dessins annexés.

### Description sommaire des dessins

La figure 1 est une représentation en plan d'une pièce d'horlogerie munie d'un cadran revêtu et décoré selon le procédé de l'invention.
Les figures 2A à 6 sont des représentations schématiques de différents modes de réalisation du procédé selon l'invention avec les étapes successives mises en œuvre.

### Description de l'invention

L'invention se rapporte à un composant destiné à l'habillage intérieur ou au mouvement d'une pièce d'horlogerie ou de bijouterie. Il peut être choisi parmi la liste non exhaustive comprenant un cadran, un rehaut, une aiguille, un index, une applique, une masse oscillante, une platine, un pont, etc. Selon l'invention, ce composant est au moins partiellement revêtu d'une couche noire. Comme décrit ci-après, l'invention se rapporte également à un ensemble de deux desdits composants au moins partiellement revêtus avec la couche noire.

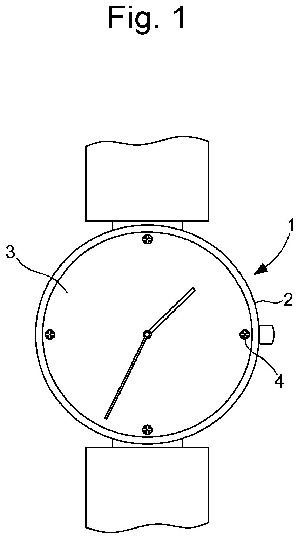

L'invention sera décrite ci-après dans le cadre d'une application à un cadran de montre 1 formé d'un substrat 2 revêtu au moins partiellement de la couche noire 3 tel que schématisé à la figure 1. Ledit substrat peut être réalisé dans un matériau métallique tel que l'acier, le titane, l'aluminium, un alliage de titane ou d'aluminium, le laiton ou tout autre alliage cuivreux. Il peut également être réalisé dans un matériau céramique, un cermet, en saphir, en verre, en silicium, en composite ou dans un polymère.

Selon l'invention, la couche noire, aussi appelée revêtement noir, est une couche comprenant majoritairement des oxydes d'aluminium AlₓO_{y} tels que de l'Al₂O₃ avec en complément des oxydes métalliques non ferreux tels que, à titre d'exemple, des oxydes de cuivre, de zinc, de nickel, de chrome, d'argent ou de manganèse. Cette couche comporte au minimum 90% d'AlₓO_{y}, de préférence 100% d'AlₓO_{y}. L'oxyde d'aluminium a une teneur en aluminium comprise entre 45% et 65 % massique et de préférence entre 45% et 50% massique. Cette couche a une épaisseur comprise entre 1 et 50 microns, de préférence entre 2 et 10 microns, et plus préférentiellement entre 4 et 7 microns. Elle peut être déposée par PVD (pour Physical Vapor Déposition en anglais), CVD (pour Chemical Vapor Déposition en anglais) ou PECVD (pour Plasma-Enhanced Chemical Vapor Déposition en anglais).

Les dépôts noirs ultra-absorbants selon l'invention ont des valeurs de réflectance dans le domaine du visible inférieures à 2% et plus particulièrement inférieures à 1.5% comme repris dans le tableau 1 pour des épaisseurs de revêtement comprises entre 4 et 7 microns. Les mesures sont des mesures de réflectance hémisphérique totale (Total Hemispherical Réflectance ou THR) obtenues par spectrométrie d'absorption lumineuse.

**Tableau 1**

| Revêtement | Réflectance Moyenne | Réflectance Min | Réflectance Max |
|---|---|---|---|
| 1 | 1.1% | 1.05% | 1.22% |
| 2 | 1.19% | 1.14% | 1.26% |

Dans le système de couleur CIELAB (conforme aux normes CIE n°15, ISO 7724/1, DIN 5033 Teil 7, ASTM E-1164), la luminance des pièces horlogères ainsi revêtues est caractérisée par :
- des valeurs de L* inférieures à 12, de préférence inférieures à 7 ;
- des valeurs de a* comprises entre -2 et +2, de préférence comprises entre -1 et +1 ;
- des valeurs de b* comprises entre -3.5 et +5, de préférence comprises entre -3.5 et +1.

Le revêtement noir présente une microstructure compacte. Cette structure compacte permet l'application de décors sans endommager le revêtement noir. Les décors peuvent être de toute nature. Il peut s'agir d'index, éventuellement photoluminescents, de pierres 4 serties ou collées sur le substrat 2 tel que montré à la figure 1, des éléments en matériau métallique, en résine, en matière composite, en bois, en nacre, etc. Il peut également s'agir d'éléments luminescents tels que des LED.

Les décors sont réalisés ou rapportés sur le revêtement noir ou sur des portions du substrat dépourvues de revêtement noir. Ces portions peuvent être dépourvues du revêtement noir dès l'origine ou le revêtement peut être sélectivement enlevé par des techniques d'usinage mécanique, laser ou par bombardement ionique ou électronique, pour des raisons fonctionnelles ou esthétiques. Les lasers de type impulsionnel et en particulier des lasers de type picoseconde, nanoseconde ou femtoseconde sont choisis pour l'ablation sélective du revêtement noir.

Les décors peuvent être construits sur le substrat par des méthodes d'impression telles que la tampographie, l'impression digitale ou la fabrication additive. Ils peuvent également être construits par électroformage ou par « hot forming » de métaux amorphes, pour les variantes où le décor est réalisé sur des portions non revêtues de la couche noire, à même le substrat métallique. Les décors peuvent également être rapportés par collage.

Selon une variante de l'invention, le décor peut également être disposé sous une couche discontinue du revêtement noir. Ainsi, le composant comprend un décor en surface du substrat tel qu'un revêtement métallique, une résine ou une laque, y compris une laque photoluminescente. Ensuite, le revêtement noir est déposé sur le décor et sélectivement enlevé à des endroits choisis pour faire apparaître le décor et créer ainsi un décor contrasté. Optionnellement, un autre décor peut être construit ou rapporté sur le revêtement noir.

La présente invention se rapporte également à un ensemble comprenant un premier composant et un second composant chacun destiné à l'habillage intérieur ou au mouvement d'une pièce d'horlogerie ou de bijouterie. Selon l'invention, le premier et le second composants comportent au moins une portion revêtue de la couche noire. Préférentiellement, le premier composant présente un mouvement relatif par rapport au second composant et est monté en regard de ce dernier. Ce premier composant est décoré. Par exemple, le premier composant est une aiguille revêtue de la couche noire et décorée, et le second composant est un cadran revêtu de la couche noire. A titre d'exemple, l'aiguille est décorée avec une pierre sertie ou collée au bout de l'aiguille.

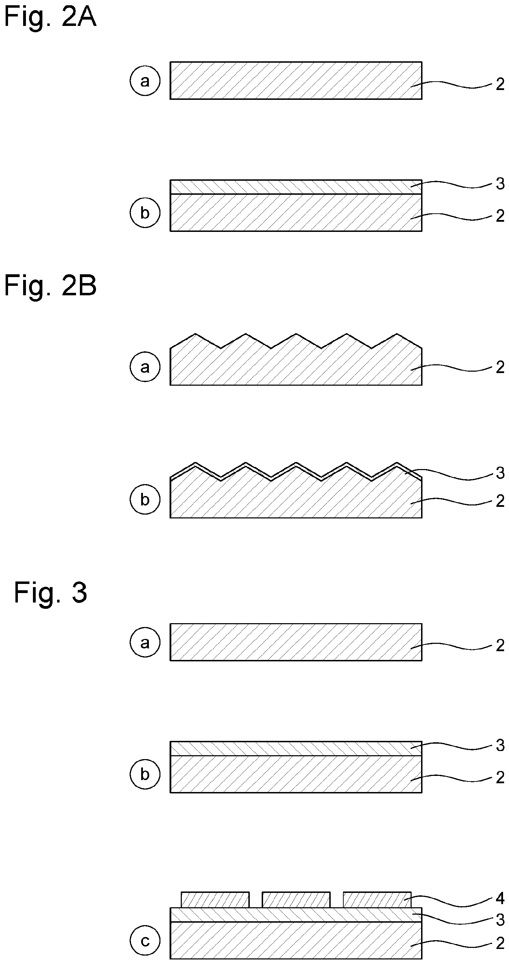

Différentes variantes de fabrication des composants selon l'invention sont représentées aux figures 2A à 6.

Le procédé de fabrication du composant comporte au moins :
- une étape a) de mise à disposition du substrat 2 et d'usinage dudit substrat. Comme schématisé à la figure 2B, le substrat 2 peut présenter une structure en relief à l'issue de l'usinage,
- une étape b) d'apport sur au moins une portion du substrat 2 de la couche noire 3 comprenant majoritairement le ou les oxydes d'aluminium.

Optionnellement, lors de l'étape a), le substrat peut subir un prétraitement de microsablage ou de microbillage afin d'augmenter la rugosité de surface (étape non représentée). Les surfaces ainsi traitées présentent une rugosité Ra (rugosité moyenne arithmétique) mesurée avec un profilomètre optique Altisurf 500 (ISO 4288 :1996/4287 :1997) comprise entre 0.4 et 5 microns et de préférence entre 0.4 et 2 microns.

En variante, toujours optionnellement, le substrat peut subir un prétraitement d'oxydation électrolytique de type anodisation ou céramisation par plasma électrolytique afin de donner un aspect noir et rugueux en surface de la pièce (étape non représentée). Pour cette variante, le substrat est de préférence réalisé dans un alliage de titane, par ex. du Ti-6Al-4V ou du Ti-CP3, d'aluminium, par ex. AA6061, AA2024, AA6082, dans un alliage mixte aluminium-titane ou des alliages aluminium-lithium. Après ce prétraitement, le substrat est soumis au traitement sous vide afin de déposer en surface le revêtement ultra-noir.

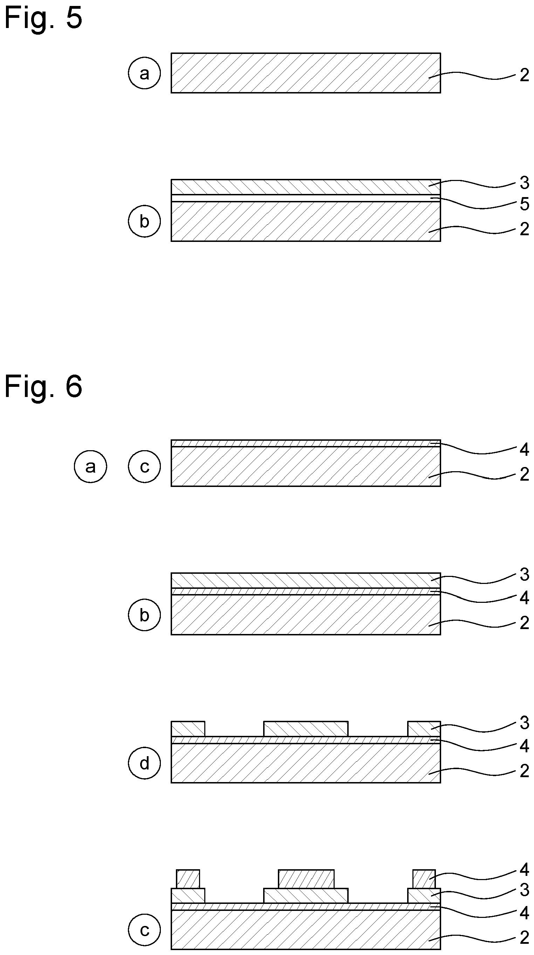

L'étape b) peut consister en une étape de dépôt de la couche noire sur le substrat par PVD, CVD ou PECVD. En variante, la couche noire est déposée par PVD, CVD ou PECVD sur un support mince de type film ou bande et collé ensuite sur le substrat (couche de colle ou adhésif 5 à la figure 5). Le film ou la bande peuvent être réalisés dans un matériau polymère ou métallique comprenant sur sa face opposée au revêtement l'adhésif destiné à être fixé sur le substrat.

Le procédé de fabrication peut en outre comporter une étape c) de décoration avant et/ou après l'étape b). L'étape de décoration peut consister à construire un décor sur la portion revêtue ou sur une portion non revêtue par la méthode d'impression ou par électroformage. L'étape de décoration peut également consister à rapporter le décor sur la portion revêtue ou non revêtue, le décor pouvant être fixé, par exemple par collage.

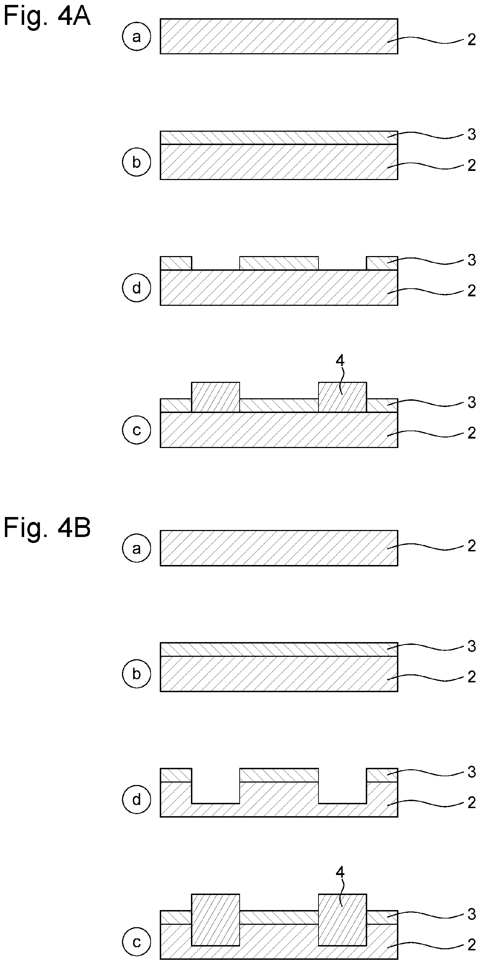

Selon les variantes des figures 3, 4A, 4B et 6, il y a au moins une étape c) de décoration postérieure au dépôt de la couche noire 3 à l'étape b). Cette étape c) de décoration peut être précédée d'une étape d) d'enlèvement sélectif de la couche noire 3 sur les zones destinées à être décorées à l'étape c) comme illustré aux figures 4A, 4B et 6. Cet enlèvement sélectif peut être limité à la couche noire 3 (fig.4A et fig.6) ou s'étendre jusque dans le substrat 2 (fig.4B).

En variante, le procédé peut comporter une étape c) de décoration avant l'étape b) de dépôt de la couche noire 3 comme illustré à la figure 6. Le substrat est usiné et décoré avec un premier décor 4. Le substrat décoré est alors revêtu avec la couche noire 3 à l'étape b). Ensuite, la couche noire 3 est sélectivement enlevée à l'étape d) pour rendre visible le premier décor 4 sur certaines portions. Le procédé de fabrication peut comporter une deuxième étape c) de décoration sur les portions comportant la couche noire 3. Préférentiellement, le deuxième décor 4 recouvre seulement partiellement la couche noire 3.

Pour toutes les variantes, le procédé peut en outre comporter une étape additionnelle (non représentée) de dépôt sur la couche noire avec ou sans décor, d'un revêtement dur de protection. Ce revêtement est un revêtement transparent de type ALD (Atomic Layer Déposition) à base d'oxyde métallique tel que du TiO₂, de l'Al₂O₃, de SiO₂ ou d'un mélange d'au moins deux de ces oxydes. Ce revêtement dur a une épaisseur comprise entre 5 à 100 nm, de préférence entre 5 et 20 nm.

### Légende

(1) Cadran
(2) Substrat
(3) Couche noire
(4) Décor, dit aussi premier décor ou deuxième décor

## Revendications

1. Composant d'habillage intérieur ou du mouvement pour une pièce d'horlogerie ou de bijouterie comprenant un substrat (2) comportant au moins une portion revêtue d'une couche noire (3) comprenant au moins un oxyde d'aluminium.

2. Composant selon la revendication 1, **caractérisé en ce que** la couche noire (3) comprend au moins 90% en poids d'oxyde d'aluminium, de préférence 100% en poids d'oxyde d'aluminium.

3. Composant selon la revendication 1 ou 2, **caractérisé en ce que** l'oxyde d'aluminium a une teneur en poids en aluminium comprise entre 45% et 65% et de préférence entre 45% et 50%.

4. Composant selon l'une des revendications précédentes, **caractérisé en ce que** la couche noire (3) a une épaisseur comprise entre 1 et 50 microns, de préférence entre 2 et 10 microns, et plus préférentiellement entre 4 et 7 microns.

5. Composant selon l'une des revendications précédentes, **caractérisé en ce qu'**il comporte un décor (4) sur la portion revêtue de la couche noire (3) ou sur une autre portion du substrat (2) dépourvue de la couche noire (3).

6. Composant selon l'une des revendications précédentes, **caractérisé en ce qu'**il comporte un autre décor (4) disposé entre le substrat (2) et la couche noire (3), ladite couche noire (3) étant discontinue pour laisser apparaître ledit autre décor (4).

7. Composant selon la revendication précédente, **caractérisé en ce que** ledit autre décor (4) est un revêtement métallique, une résine ou une laque, y compris une laque photoluminescente.

8. Composant selon l'une des revendications 5 à 7, **caractérisé en ce que** le décor (4) est réalisé dans un matériau métallique, polymérique, composite, dans du bois ou de la nacre ou **en ce qu'**il comporte une LED.

9. Composant selon l'une des revendications 5 à 8, **caractérisé en ce que** le décor (4) est un index ou une pierre collée ou sertie sur le substrat (2).

10. Composant selon la revendication précédente, **caractérisé en ce que** l'index est photoluminescent.

11. Composant selon l'une des revendications précédentes, **caractérisé en ce que** la couche noire (3) est revêtue d'une couche protectrice à base d'oxyde métallique.

12. Composant selon la revendication précédente, **caractérisé en ce que** la couche protectrice comporte du TiO₂, de l'Al₂O₃ et/ou du SiO₂.

13. Composant selon l'une des revendications précédentes, **caractérisé en ce qu'**il est choisi parmi le groupe comprenant un cadran, un rehaut, un index, une aiguille, une applique, une masse oscillante, une platine et un pont.

14. Composant selon l'une des revendications précédentes, **caractérisé en ce que** le substrat (2) comporte sur sa portion revêtue une structure en relief.

15. Composant selon l'une des revendications précédentes, **caractérisé en ce qu'**il présente dans le système de couleur CIELAB une valeur de L* inférieure à 12, de préférence inférieure à 7, une valeur de a* comprise entre -2 et +2, de préférence comprise entre -1 et +1, une valeur de b* comprise entre -3.5 et +5, de préférence comprise entre -3.5 et +1.

16. Ensemble comprenant le composant selon l'une des revendications précédentes et un autre composant d'habillage intérieur ou du mouvement pour une pièce d'horlogerie ou de bijouterie, ledit autre composant étant revêtu au moins partiellement de ladite couche noire (3).

17. Ensemble selon la revendication précédente, **caractérisé en ce que** l'autre composant est disposé en regard dudit composant et monté avec un mouvement relatif par rapport audit composant, l'autre composant comprenant un décor (4).

18. Ensemble selon la revendication 16 ou 17, **caractérisé en ce que** l'autre composant est une aiguille et **en ce que** le composant est un cadran, ladite aiguille comprenant un décor formé d'une pierre (4).

19. Pièce d'horlogerie ou de bijouterie comprenant le composant selon l'une des revendications 1 à 15 ou l'ensemble selon l'une des revendications 16 à 18.

20. Procédé de fabrication d'un composant destiné à l'habillage intérieur ou au mouvement d'une pièce d'horlogerie ou de bijouterie, ledit composant comportant un substrat (2) revêtu au moins partiellement d'une couche noire (3) comprenant un oxyde d'aluminium, le procédé comprenant :
- une étape a) de mise à disposition du substrat (2) et d'usinage dudit substrat (2),
- une étape b) d'apport de la couche noire (3) sur au moins une portion du substrat (2).

21. Procédé de fabrication selon la revendication précédente, **caractérisé en ce que** l'étape b) d'apport de la couche noire (3) est une étape de dépôt de la couche noire (3) sur le substrat (2) ou une étape de dépose d'un film ou d'une bande revêtu de la couche noire (3) sur le substrat (2).

22. Procédé de fabrication selon la revendication 20 ou 21, **caractérisé en ce qu'**il comporte une étape c) de décoration avant et/ou après l'étape b).

23. Procédé de fabrication selon la revendication précédente, **caractérisé en ce que** l'étape c) consiste à réaliser un décor (4) par fabrication additive, impression digitale, tampographie, « hot forming », électroformage ou consiste à rapporter un décor (4).

24. Procédé de fabrication selon l'une des revendications 20 à 23, **caractérisé en ce qu'**il comporte, après l'étape b), une étape d) d'enlèvement sélectif de la couche noire (3).

25. Procédé de fabrication selon la revendication précédente, **caractérisé en ce que** l'enlèvement sélectif s'étend jusque dans le substrat (2).

26. Procédé de fabrication selon l'une des revendications 24 à 25, **caractérisé en ce que** l'enlèvement sélectif est réalisé avec un laser impulsionnel.

27. Procédé de fabrication selon l'une des revendications 24 à 26, **caractérisé en ce qu'**il comporte successivement l'étape c) de décoration, l'étape b) d'apport de la couche noire (3) et l'étape d) d'enlèvement sélectif de la couche noire (3) pour rendre partiellement visible le décor (4) déposée à l'étape c).

28. Procédé de fabrication selon la revendication précédente, **caractérisé en ce qu'**il comporte après l'étape d), une autre étape c) de décoration sur la couche noire (3).

29. Procédé de fabrication selon l'une des revendications 20 à 28, **caractérisé en ce que** la couche noire (3) est déposée par PVD, CVD ou PECVD.

30. Procédé de fabrication selon l'une des revendications 20 à 29, **caractérisé en ce que** le substrat (2) est soumis lors de l'étape a) à un prétraitement de microsablage ou de microbillage afin d'augmenter la rugosité de surface avec une rugosité Ra comprise entre 0.4 et 5 microns et de préférence entre 0.4 et 2 microns.

31. Procédé de fabrication selon l'une des revendications 20 à 29, **caractérisé en ce que** le substrat (2) est soumis lors de l'étape a) à un prétraitement d'oxydation électrolytique de type anodisation ou céramisation par plasma électrolytique.

32. Procédé de fabrication selon l'une des revendications 20 à 31, **caractérisé en ce qu'**il comporte après l'étape b), une étape de dépôt d'une couche protectrice à base d'un oxyde métallique.
